# EUROPEAN PATENT SPECIFICATION

(11) **EP 2 691 939 B1**
(45) Date of publication and mention of the grant of the patent: **01.08.2018**
(21) Application number: 11862649.8
(22) Date of filing: 31.03.2011
(51) Int. Cl.: G06T 7/00

(54) **AUTOMATIC DETERMINATION OF COMPLIANCE OF A PART WITH A REFERENCE DRAWING**
AUTOMATISCHE BESTIMMUNG DER KONFORMITÄT EINES TEILS MIT EINER REFERENZZEICHNUNG
DÉTERMINATION AUTOMATIQUE DE LA CONFORMITÉ D'UNE PIÈCE À UN DESSIN DE RÉFÉRENCE

(43) Date of publication of application: 05.02.2014
(73) Proprietor: Visionx Inc., Pointe-Claire, Québec H9S 4K9 (CA)
(72) Inventor: BEAUCHEMIN, Patrick, Pointe-Claire, Quebec H9R 1A6 (CA)
(74) Representative: Nony
(86) International application number: PCT/CA2011/000337
(87) International publication number: WO 2012/129634

(56) References cited:
- EP-A1- 1 494 003
- CA-A1- 2 106 146
- US-A- 5 657 395
- US-A1- 2004 120 571
- US-A1- 2010 225 666
- US-A1- 2010 225 666
- Anonymous: "Geomagic Qualify Complete Inspection -Plastic Quick Start Guide", , 29 November 2005 (2005-11-29), XP055151337, Retrieved from the Internet: URL:http://www.comp.nus.edu.sg/~medialab/g raphics lab/Geomagic Q8-CompleteInspection-Plastic.pdf [retrieved on 2014-11-06]
- Anonymous: "Geomagic Qualify 8 What's New Guide", , 24 November 2005 (2005-11-24), XP055151357, Retrieved from the Internet: URL:http://www.comp.nus.edu.sg/~medialab/g raphics lab/Geomagic Q8_Feature.pdf [retrieved on 2014-11-06]
- Anonymous: "Digital Optical Comparators / Digital Profile Projectors", , 29 October 2010 (2010-10-29), pages 1-5, XP055151363, Retrieved from the Internet: URL:https://web.archive.org/web/2010102904 1137/http://www.visionxinc.com/optical-com parators-profile-projectors/about-digital- optical-comparators.html [retrieved on 2014-11-06]
- Anonymous: "Homepage of the Graphic Lab of the NUS", , 20 September 2006 (2006-09-20), XP055151384, Retrieved from the Internet: URL:http://www.comp.nus.edu.sg/~medialab/g raphics%20lab/graphics%20lab.htm [retrieved on 2014-11-06]
- Anonymous: "Index of /~medialab/graphics lab", , September 2006 (2006-09), XP055151378, Retrieved from the Internet: URL:http://www.comp.nus.edu.sg/~medialab/g raphics%20lab/ [retrieved on 2014-11-06]
- Al Dean: "Geomagic Qualify 12: A Solid Quality Release", Desktop Engineering, 1 May 2010 (2010-05-01), XP055151393, Retrieved from the Internet: URL:http://www.deskeng.com/de/geomagic-qua lify-12-a-solid-quality-release/ [retrieved on 2014-11-06]
- VISIONX: 'Digital Optical Comparators / Digital Profile Projectors' 29 October 2010, XP008171362 Retrieved from the Internet: <URL:http://web.archive. org/web/20101029041137/http://www.visionxin c.com/optical-comparators-profile-projector s/about-digital-optical-comparators.html>
- AILISTO: 'CAD and Vision in Rangefinder-based Dimensional Metrology' INTERNATIONAL CONFERENCE ON RECENT ADVANCES IN 3-D DIGITAL LMAGING AND MODELING 15 May 1997, pages 251 - 260, XP010234183
- Anonymous: "3D scanner - Wikipedia", , 24 December 2010 (2010-12-24), XP055335617, Retrieved from the Internet: URL:https://en.wikipedia.org/w/index.php?t itle=3D_scanner&oldid=403960178#Triangulat ion [retrieved on 2017-01-16]

## Description

### Field of the invention

The present invention relates to a system and method for automatically determining if a part is within a predetermined tolerance, either in a control section, or for the whole part.

### Background of the invention

In manufacturing processes, it is almost always necessary to perform quality control on a part so manufactured. In some cases, this quality control will permit the manufacturer to sell the part for a better price if the part is within tighter tolerances. Additionally, in some industries such as the aerospace industry, or the electronics industry, parts will be rejected if they are not manufactured to strict tolerances.

In the past, a comparison of the part to engineering drawings has been done manually or through vision systems, but using a paper copy of the drawings, with the inherent disadvantages that this may entail.

The Assignee of the present application has filed application no. PCT/CA2010/000295, directed to a system and method for overlaying an image of a drawing to an image of the part, on a screen. Two of the many advantages of this system are that scaling of the drawing can be done using conventional image manipulation techniques, and also that the alignment of the drawing and the part can be performed either manually or automatically.

The software *Geomagic Qualify* enables the comparison of an acquired 3D point cloud of a part with a corresponding CAD-model. The 3D point cloud and the CAD-model are aligned, and the deviations over the whole surface are computed and displayed to the user.

### Summary of the invention

It is an object of the invention to provide a system and method for automatically determining if a part is within tolerances, as defined in claims 5 and 1 respectively.

### Brief description of the drawings

The present invention will be better understood after reading a description of a preferred embodiment thereof, made in reference to the following drawings, in which:
Figure 1 is a schematic representation of a portion of a part illustrated in a CAD drawing, showing a line selected for a control section;
Figure 2 additionally illustrates the positive direction tolerance, and negative direction tolerance;
Figure 3 shows a part on a display, where the CAD drawing is overlaid on the image of the part, and showing control section points A to H
Figure 4 shows where a deviation from nominal occurs between a part and a CAD drawing of the same part;
Figure 5 shows a part with its CAD drawing overlaid thereon, where the part is determined to pass inspection given the deviation values at selected control points being below a predetermined threshold;
Figure 6 shows a part with its CAD drawing overlaid thereon, where the upper portion of the part is not smooth, but rather presents a jagged edge;
Figure 7 shows a portion of a CAD drawing and a plurality of virtual control sections for evaluating geometry of the part;
Figure 8 shows a part with a portion of a CAD drawing overlaid thereon, showing different tolerance bands for different portions of the part;
Figure 9 shows the positive direction tolerance band and negative direction tolerance band for the portion of the CAD drawing of Figure 7;
Figure 10 shows a part with its CAD drawing overlaid thereon, where the part is determined to pass inspection given that the part is within the positive and negative direction tolerance bands for a whole geometry;
Figure 11 shows a part with its CAD drawing overlaid thereon, where the part is determined to fail inspection given that portions of the part are outside the positive direction tolerance bands for a whole geometry;
Figure 12 shows a part with its CAD drawing overlaid thereon showing tolerance bands in conjunction with control sections;

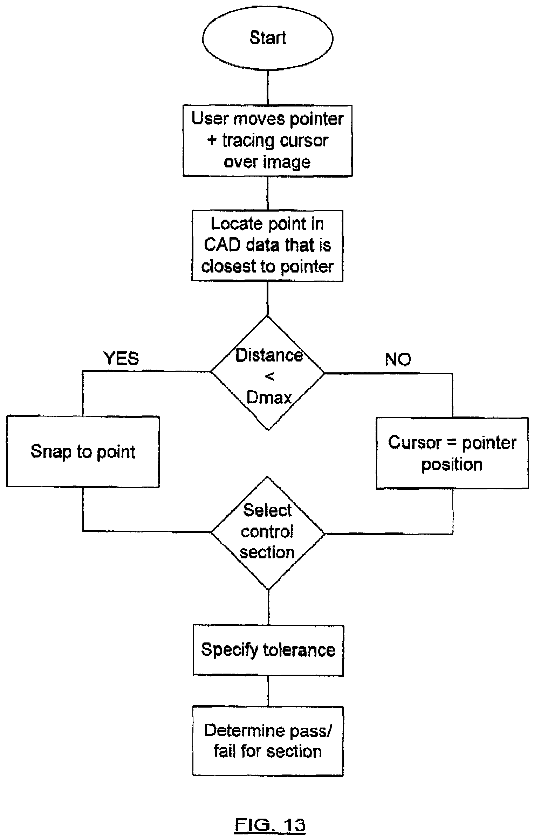

Figure 13 is a schematic representation of the steps for performing a verification for a single control section on a part;
Figure 14 is a schematic representation of the steps for performing verification for a geometric entity;
Figure 15 is a schematic representation of a system used to carry out a preferred embodiment of the invention.

### Description of a preferred embodiment of the invention

The present invention finds particular use in an imaging system such as the one described in application no. PCT/CA2010/000295 Thus, the present invention finds use in a system that is capable of overlaying a part's appropriately scaled, translated and rotated CAD data on top of the live or still video image of the part. Note, however, that the present patent application should not be limited to the specific imaging system described in that application, but that the invention herein described can be used in all computerized imaging systems.

In a preferred embodiment, the system of the present invention includes a lens 111, a digital camera 113 and a computer, or other appropriate data processing system, 115 running the appropriate hardware and software to interface with the camera

Since such a system is designed to study both small and large items, the system preferable includes one or more monitors 117. A preferred implementation provides for multiple monitors which allows the high-resolution image produced by the camera to be displayed fully (i.e. in 1:1 resolution on the bank of monitors, so that every pixel coming from the camera corresponds to a pixel on the bank of monitors, and allows for room for other windows).

Preferably, the system also includes illumination means 119 (either transmitted and/or reflected, for back- and/or front-illumination, respectively). Means 121 for mounting the camera, lens and illumination, such as brackets, hardware and structural elements are also provided, as are means 123 for mounting the part 100 between the camera and the lens.

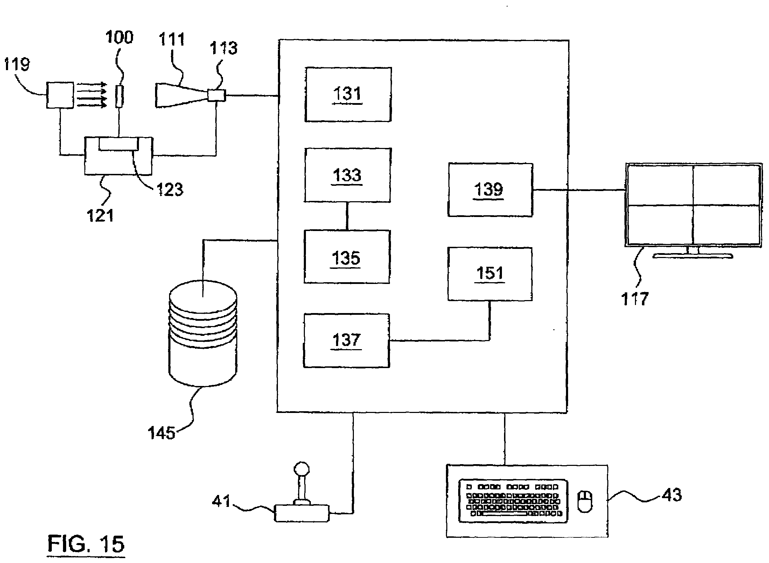

The computer 115 is programmed with a variety of modules 131, 133, 135, 137, 139 and 151, only a portion of which are labeled on Figure 15, for manipulating the signal received from the camera 113, performing edge detection or pattern recognition on the image, for obtaining the CAD drawing from database 145, and for performing the various calculations according to the invention.

The computer 115 further includes input devices 41, 43, such as a joystick or keyboard and mouse, for permitting the user to interact with the computer 115.

Other than for the specific computing functions described herein, computer 115 is programmed and functions as any other computing devices. Notwithstanding the generality of the preceding, a person skilled in the art will readily recognize that the system and method of the present invention can be implemented on a desktop system, a server system, a workstation system, or may even be deployed through an intranet or extranet.

In one aspect, the present invention concerns a system and method to automatically determine, in real-time, if the part matches its CAD data, to within user-specified tolerances, at specific locations. This will be referred to as the "Control Section-Based Auto Pass / Fail" scheme.

If a full part approach is required, the present invention concerns in another aspect a system and method to automatically determine, in real-time, if the part matches its CAD data, to within user-specified tolerances, across complete geometric objects. This will be referred to the "Geometry-Based Auto Pass / Fail" scheme.

These computational schemes are described below.

### Control Section-Based Auto Pass/Fail

In summary, the Auto Pass/Fail scheme allows the user to setup "control sections". A control section is located at a single point, has an orientation and has a general bi-directional tolerance associated to it. A classic example of a bi-directional tolerance would be +0,005" / -0.001". Note that in the context of the present invention, there is no limitation as to the values of the bi-directional tolerance. The present invention supports so-called "plus/plus" tolerances (e.g. +0.005" / +0.001"), "minus/minus" tolerances (e.g. -0.001" / -0.005") as well as zero-valued tolerances (effectively: unidirectional tolerances - e.g. +0.005" / 0" or 0" / -0.005" - or zero tolerances - e.g. +/- 0"). Stated differently: so-called "plus/plus" tolerances occur when both of the tolerance limits are on the nominal's positive side. Inversely, both of the tolerance limits are on the negative side of the nominal in the case of "minus/minus" tolerances.

Control sections would typically (but not necessarily) be located directly on the CAD data and be normal to the CAD geometry at that location.

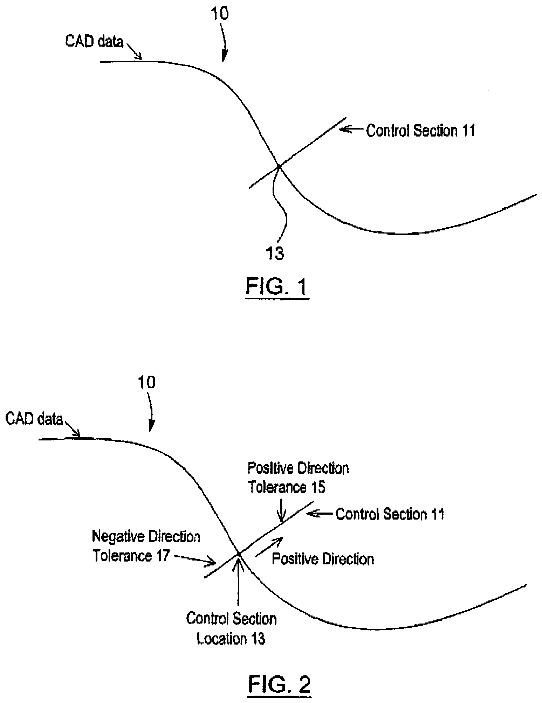

For example, Figure 1 shows a portion 10 of a part as represented by a CAD drawing where a control section 11 has been placed. In a preferred embodiment, the control section 11 is normal to the CAD drawing, at the point 13 where the control section 11 is placed.

Figure 2 expands on Figure 1, and for the purposes of calculating positive and negative deviations from normal, shows a positive direction tolerance 15 and a negative direction tolerance 17.

### Setting Up Control Sections

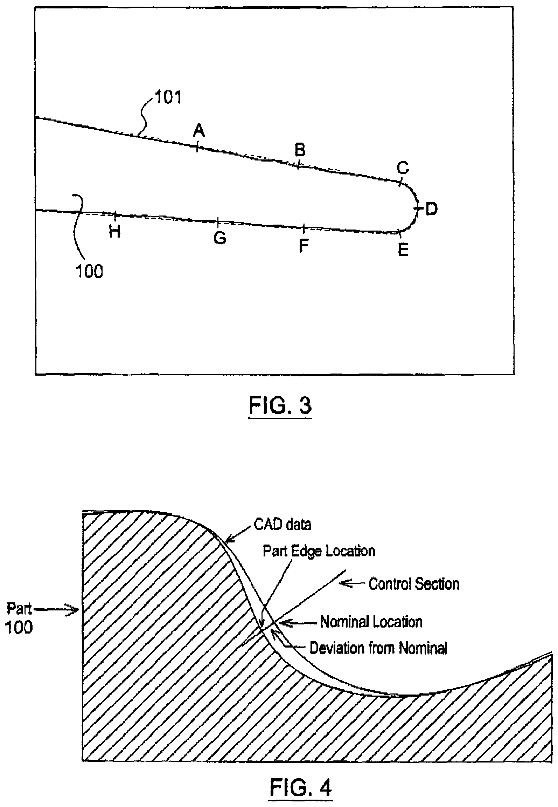

Many different approaches are possible to setup control sections 11. In a preferred embodiment, the approach to allow users to setup these control sections 11 manually is as follows:
Using the mouse or another pointing device41 , the user moves a pointer and a tracking cursor over the image of the part and the overlaid CAD data. The system then continuously and in real time locates the point 13 in the CAD data that is closest to the pointer. If the distance between this closest point and the pointer is less than a user-specified maximum distance (i.e. if the pointer is "in the neighborhood" of the CAD data) then the cursor "snaps" to this closest point. If not, the cursor's position is the same as the pointer's. The cursor moves with the pointer, snapping to the CAD data in this way until the user "sets" the point (by - for example - clicking on the mouse button). This determines the location of the control section 13. If the selected point is on the CAD data then in a preferred implementation, the system allows the user to automatically set the control section's orientation as being normal to the CAD data at that point. The user can then indicate which direction corresponds to the positive direction. Note that in the preferred implementation, the convention is that the positive direction is the direction away from the material in the case where the control section is being set on the outside edge of the part. Figure 4 shows a detailed schematic representation of the part and the CAD data, and the deviation from normal (in this case, a negative deviation).

The user can then specify the control section's bi-directional tolerances described above.

The reader will note that there is no limit on the number of control sections that the present invention supports. Also, different control sections can obviously have different tolerance values.

Note that, along with the ability to set up control sections manually as described above, it is also possible to supply to the pass / fail algorithm the control section information obtained from the CAD data itself via electronic file, for example.

Figure 3 shows an example of control sections A to H being setup at locations in the CAD data that corresponds to the outside edge of a part 100. The dashed line 101 represents the CAD data.

### Carrying Out Control Section-Based Auto Pass/Fail Calculations

With this control section information, the system of the invention can automatically determine, in real-time, if the part matches the CAD data to within the user-prescribed tolerances. Specifically, the system works on every image in the camera's live video stream (or still image) and, at every control section, determines the part's deviation from nominal. Considering the case where the control sections are setup on the CAD data at the nominal position of the part's outside edges, then the deviation from nominal is the difference (i.e. the distance away from the control section's location measured along the control section's direction) between the part's true position and its nominal position. The edge position can be obtained by using edge detection tools, for example. Pattern matching tools can also be used to obtain feature location. This can be especially useful when considering features with weak edges (a condition that is more frequent in the case of certain edges inside the part) or where there are many edges that can possibly "confuse" edge detection tools. A person skilled in the art will readily recognize that other approaches for edge and feature location are also possible.

The value of the deviation from nominal at every control section can be displayed to the user and continuously updated for every image in the case of a live video stream.

A pass / fail result is obtained at every control section by comparing the deviation from nominal against the tolerance range. If the deviation from nominal is within the user-prescribed tolerance range then this control section is said to "pass" and if it is not then it is said to "fail". By combining the pass / fail result of all of the control sections, an overall pass / fail result can be obtained. In most applications, the overall result is "pass" only when all of the control section results are "pass". However, in certain practical applications, an overall "pass" result can be obtained even in the presence of a certain (typically small) percentage of "failed" control sections.

In a preferred implementation, the pass fail result at every control section is shown using color coding (typically: red for fail and green for pass).

Figure 4 shows how the deviation from nominal is obtained by measuring (in the image space) the distance along the control section between the part's location and its nominal location. The real-world value of the part's deviation from nominal at the control section is obtained by carrying out the inverse (i.e. image-space-to-CAD-space) transform of the distance measured on the image.

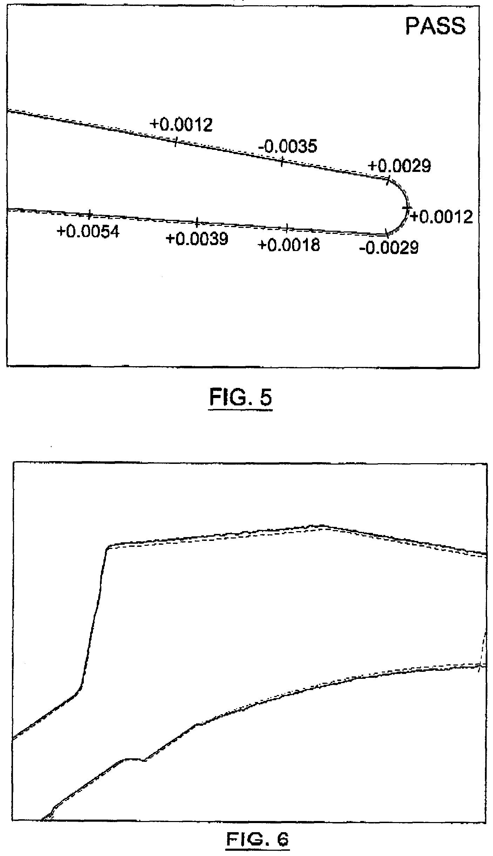

Figure 5 shows an example the results of a control section-based auto pass / fail calculation, with the deviation from nominal at every control section.

Control sections can be positioned both inside and outside the system's optical field-of-view (which is especially useful in the case of parts that are larger than the field of view, for example). By having the CAD data (and the control section information, which is "tied" to it) "track the stage motion" (based on feedback from the stage's encoder) the part can be compared to the CAD data beyond the system's optical field of view.

The reader will appreciate that in order to be able to carry out this automated control section-based part-to-CAD comparison, the part and the CAD data need to be aligned. This can be done manually or automatically.

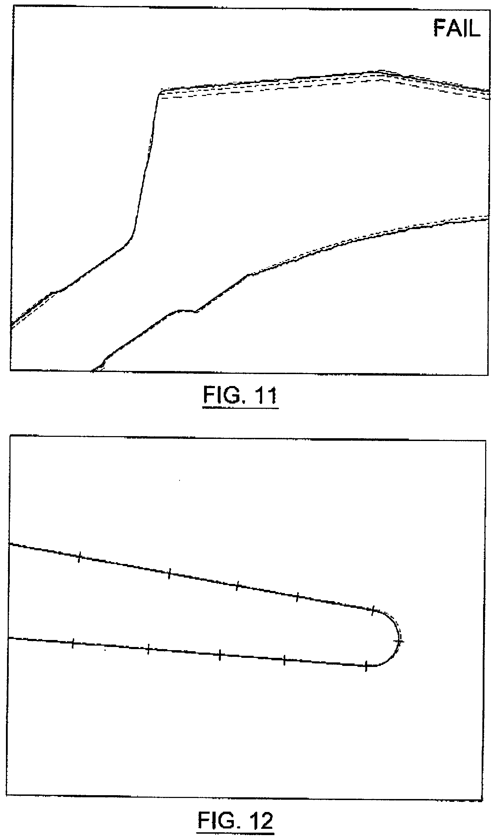

The following presents the principal steps involved in the control section-based auto pass/fail calculations according to a preferred embodiment of the invention (see Figure 12):
As mentioned above, the user with a pointing device such as a mouse or a joystick, and and input device such as a keyboard or touch screen, will enter the desired number of control sections as well as the various parameters for each control section, i.e. location, orientation, tolerance and positive direction.

In a preferred embodiment, the orientation will by default be normal to the CAD data at the control section, if applicable, but the system is adapted to receive a different orientation as specified by the user.

Once the control sections have been set, the system will apply the CAD overlay current translation, rotation and scaling to each control section geometry. In other words, the system applies a CAD-space to image-space transformation of the control section.

Thereafter, continuously for every image in the live video stream and for every control section, the system calculates the part's deviation from nominal at the location of the control section, and compares the deviation against the control section's tolerance. It will be noted that the tolerance can be user specified or mined from the CAD drawing itself. The system thus produces a pass/fail result for the control section.

The system then determines an overall pass/fail result based on a combination of each individual pass/fail result for each control section of a given part.

Of course, the threshold for individual pass/fail and overall pass/fail are predetermined by the user, and will change from part to part, and even within a part, tolerances can be different.

### Geometry-Based Auto Pass/Fail

The above control section-based auto pass / fail scheme produces very accurate results at each of the control sections and has the advantage of being very computationally efficient. However, it provides incomplete coverage of the part. There is thus a risk of producing so-called false-pass results. This would be the case if the part were out-of-tolerance at some point where no control section is defined.

Figure 6 shows an example of a feature that is ill-suited to the control section-based approach (because the feature of interest on the part has many very significant "peaks and valleys").

Another example of a problematic situation is a machined part with "flashing".

To address this shortcoming, the present invention proposes a calculation scheme which is an extension to the above scheme and that automatically provides coverage of entire geometric entities at full resolution, referred to as "Geometry-Based Auto Pass / Fail".

In this case, the user selects complete geometric components (such as LINE, ARC, ELLIPSE, SPLINE, CIRCLE, POLYLINE, LWPOLYLINE ENTITIES as well as any other CAD geometric component).

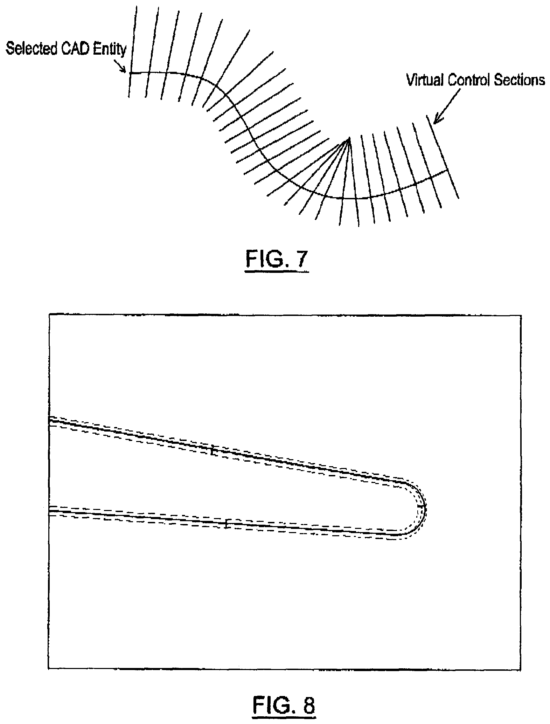

Many different approaches are possible to define the geometry to be used for auto pass/fail calculations. In a preferred implementation, when the user is defining the geometry to be used for this auto pass / fail analysis, a "snap to CAD" capability analogous the one described above is provided, except that in this case the user is allowed to select the entire geometric object closest to the pointer (and still within the pointer's "neighborhood"), instead of a single point. Once a geometric object is selected, the system creates "virtual" control sections at a density that corresponds to a coefficient times the CAD-space (or: real-world) equivalent of the pixel-to-pixel distance. The orientation of each one of these virtual control sections is set as normal to the geometric object at the virtual control section's position (see Figure 7)

With a density coefficient of 1.0 this approach ensures that the resolution of the auto pass / fail analysis corresponds to the system's full resolution.

The density coefficient is included in the case where the user wishes to consider a coarser virtual control section density (which corresponds to a coefficient value greater than 1.0). This provides the benefit of speeding up calculations significantly (there is a linear relationship between the speedup and the value of the coefficient), while maintaining a more-than-acceptable resolution (i.e. in many practical situations, if an out-of-tolerance condition occurs only over a distance of one or two pixels, for example, users will often want to disregard it anyway...).

Note also that it makes no sense to use a coefficient value of less than 1.0 as the resolution of the overall pass / fail result would continue to be limited by the system's resolution. In this case, the finer virtual control section resolution would provide no benefit but would of course increase computational cost.

As in the case of the control section based scheme, the positive direction needs to be indicated and the bi-directional tolerances need to be set. Note, however, that in the case of the geometry-based auto pass / fail scheme, tolerances can be variable along a geometric object (a common example is when tolerances vary linearly along a geometric object). Stated differently: there is no requirement that all of the virtual control sections along a geometric object have the same tolerances values.

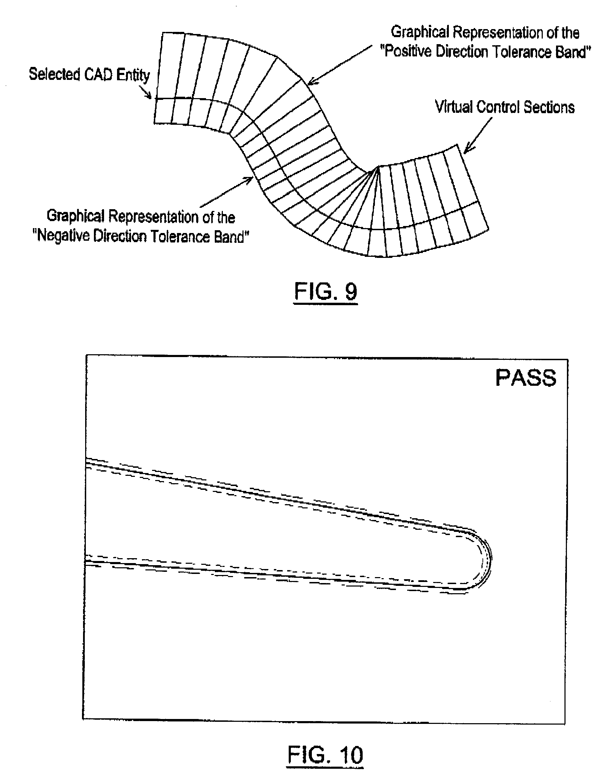

Figure 9 shows how virtual control sections are automatically created along a geometric entity (a SPLINE entity), with the spacing between neighboring virtual control sections being a function of the density coefficient and the image space pixel spacing.

Figures 8 and 9 illustrate "tolerance bands" drawn along a line between the tips of all of the neighboring virtual control sections, along both the positive tolerance direction and the negative tolerance direction. This representation effectively shows the "tolerance band" along each selected geometric object.

### Carrying Out Geometry-Based Auto Pass/Fail Calculations

With the geometry information setup as described above, the geometry-based auto pass / fail algorithm can automatically determine, in real-time and at every virtual control section, if the part matches the CAD data to within the user-prescribed tolerances. This result is obtained at every virtual control section in the same manner as described above for the control section based approach. And, as previously, this geometry-based approach works on every image in the camera's live video stream. And, also as previously, deviations from nominal (typically, but not necessarily, the maximum positive deviation and the maximum negative deviation from nominal over a geometric object as well as their location) can be displayed to the user and continuously updated for every image in the live video stream. Also as previously, the preferred implementation uses color coding to indicate the location of in- and out-of-tolerance conditions. And as previously, the pass / fail result from all of the virtual control sections can be combined to produce an overall pass / fail result. And again as previously: virtual control sections can be positioned both inside and outside the system's optical field-of-view.

Figure11 and 12 show examples of the results of geometry-based auto pass / fail calculations.

The reader will appreciate that in order to be able to carry out this automated geometry-based part-to-CAD comparison, the part and the CAD data need to be aligned. This can be done manually or automatically.

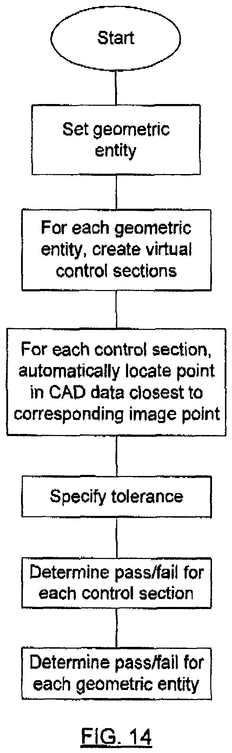

The principal steps involved in the geometry-based auto pass/fail calculations are similar to those described above for the control-based method, with the appropriate modifications, as detailed below (see Figure 14).

The user will set up the environment by specifying the number of geometric entities, and for each entity will specify the geometry: tolerances (constant or variable along the entity), density coefficient and positive direction.

Once the entities are defined, virtual control sections are created within the entity with a resolution (i.e. spacing) determined by the density coefficient. Thereafter, the pass/fail computations as described above are performed for each virtual control section, and an overall pass/fail determination is made.

The examples and descriptions above all relate to two-dimensional comparisons between the part and its CAD data. It is important to note, however, that both schemes can be extended to the third dimension (to compare depth and height at various points along the part, for example) using classic LASER triangulation, for example.

Additionally, the present description has been made in reference to a system which includes a display for displaying in real time an image stream obtained from the camera, or a still image obtained from the camera. A person skilled in the art will recognize that the invention can be practiced without the display system. Indeed, a still image of the part can be stored in memory, and the image manipulations can be performed within the memory. All that is required is that the system be provided with the control points and/or the geometric shape to study. A person skilled in the art will further appreciate that the present system can be implemented in a manufacturing process, where each part, or portion of a part, can be inspected as they are conveyed from one area to another. Such an implementation can further include a control system connected to the conveyor, for example, and be operatively connected thereto to "reject" the parts that are outside of the predetermined tolerance values. This implementation would greatly increase the manufacturing throughput in that it would not be necessary to remove a part from the manufacturing line, place it in an inspection area, inspect the part, and then accept or reject it. The system of the present invention can be seamlessly integrated with the appropriate imaging equipment connected to a processing unit as described herein.

Although the present invention has been described by way of a preferred embodiment thereof, it should be understood that any modifications thereto within the scope of the appended claims are within the present invention.

## Claims

1. A method for determining if a part is manufactured within predefined tolerances, the method comprising the steps of:
a) providing a camera for capturing a single two-dimensional image or a two-dimensional image stream of a part;
b) receiving with a computing module the image or image stream;
c) obtaining, scaling, positioning and displaying a CAD-drawing of said part on a display unit;
d) overlaying the CAD-drawing on the image or image stream on a display so that the CAD-drawing and the part image are aligned;
e) defining at least one geometric entity in the CAD-drawing, said geometric entity being a portion of said part, and for each entity defining a density coefficient that is equal to or greater than 1;
f) defining a plurality of virtual control sections within each of said geometric entity, said plurality of virtual control sections being created at a density that corresponds to the density coefficient times the CAD-space equivalent to the pixel-to-pixel distance;
g) for each virtual control section, determining the orientation thereof;
h) performing a CAD-space to image-space transformation of each virtual control section;
i) calculating a deviation between the CAD drawing and the part at each virtual control section based on the transformation performed in step h);
j) providing the user with either an indication of the deviation between the CAD drawing and the part at each virtual control section or an indication of the minimum and maximum deviations between the CAD drawing and the part over the geometric entity and the location on the geometric entity of these minimum and maximum deviations;
k) comparing the deviation to a predetermined tolerance in order to determine if the part at each virtual control section is within the predetermined tolerance, a tolerance at one virtual control section being equal or different from a tolerance at another virtual control section; and
l) providing a user with an indication of the determination of each virtual control section being within the predetermined tolerance.

2. A method according to claim 1, wherein said step j) includes the step of visually displaying the indication on said display unit.

3. A method according to claim 1, wherein said step l) includes the step of visually displaying the indication on said display unit.

4. A method according to claim 1, further comprising presenting the user with an overall pass/fail indication, based on a combination of each pass/fail determination for each virtual control section.

5. A system for visually comparing in if a part to a CAD-drawing of said part in computer memory or on a screen, the system being adapted to perform all the steps of the method of claim 1.

6. A system according to claim 5, wherein said system is adapted to present the user with an overall pass/fail indication, based on a combination of each pass/fail determination for each virtual control section.

7. A method according to claim 1, wherein a tolerance to each control section varies along said geometric entity.

## Patentansprüche

1. Verfahren zum Feststellen, ob ein Teil innerhalb vordefinierter Toleranzen gefertigt wurde, wobei in den Schritten des Verfahrens:
a) eine Kamera zum Aufnehmen eines einzelnen zweidimensionalen Bilds oder einer zweidimensionalen Bildfolge eines Teils vorgesehen wird,
b) das Bild oder die Bildfolge mit einem Berechnungsmodul empfangen wird,
c) eine CAD-Zeichnung des Teils erhalten, skaliert, positioniert und auf einer Anzeigeeinheit angezeigt wird,
d) die CAD-Zeichnung auf das Bild oder die Bildfolge auf einer Anzeige so überlagert wird, dass die CAD-Zeichnung und das Bild des Teils aufeinander ausgerichtet sind,
e) wenigstens eine geometrische Einheit in der CAD-Zeichnung definiert wird, wobei die geometrische Einheit ein Abschnitt des Teils ist, und für jede Einheit ein Dichtekoeffizient definiert wird, der größer gleich 1 ist,
f) mehrere virtuelle Kontrollabschnitte innerhalb jeder der geometrischen Einheiten definiert werden, wobei die mehreren virtuellen Kontrollabschnitte mit einer Dichte erzeugt werden, die dem Dichtekoeffizienten mal dem zu dem Pixelzu-Pixel-Abstand äquivalenten CAD-Raum entspricht,
g) für jeden virtuellen Kontrollabschnitt dessen Orientierung bestimmt wird,
h) für jeden virtuellen Kontrollabschnitt eine CAD-Raum-zu-Bild-Raum-Transformation durchgeführt wird,
i) basierend auf der in Schritt h) durchgeführten Transformation an jedem virtuellen Kontrollabschnitt eine Abweichung zwischen der CAD-Zeichnung und dem Teil berechnet wird,
j) der Benutzer entweder eine Angabe der Abweichung zwischen der CAD-Zeichnung und dem Teil bei jedem virtuellen Kontrollabschnitt oder eine Angabe der minimalen und der maximalen Abweichungen zwischen der CAD-Zeichnung und dem Teil über die geometrische Einheit sowie den Ort dieser minimalen und maximalen Abweichungen auf der geometrischen Einheit erhält,
k) die Abweichung mit einer vorbestimmten Toleranz verglichen wird, um festzustellen, ob das Teil an jedem virtuellen Kontrollabschnitt innerhalb der vorbestimmten Toleranz liegt, wobei eine Toleranz an einem virtuellen Kontrollabschnitt gleich oder verschieden von einer Toleranz an einem anderen virtuellen Kontrollabschnitt ist, und
l) ein Benutzer eine Feststellungsangabe darüber erhält, ob der jeweilige virtuellen Kontrollabschnitt innerhalb der Toleranz liegt.

2. Verfahren nach Anspruch 1, wobei in dem Schritt j) die Angabe visuell auf der Anzeigeeinheit angezeigt wird.

3. Verfahren nach Anspruch 1, wobei im Schritt l) die Angabe visuell auf der Anzeigeeinheit angezeigt wird.

4. Verfahren nach Anspruch 1, in dem ferner dem Benutzer basierend auf einer Kombination jeder Bestehens/Fehler-Feststellung für jeden virtuellen Kontrollabschnitt eine Gesamt-Bestehens/Fehler-Angabe präsentiert wird.

5. System zum visuellen Vergleichen, ob ein Teil einer CAD-Zeichnung des Teils in einem Computerspeicher oder auf einem Bildschirm entspricht, wobei das System dazu ausgelegt ist, alle Schritte des Verfahrens nach Anspruch 1 durchzuführen.

6. System nach Anspruch 5, wobei das System dazu ausgelegt ist, dem Benutzer basierend auf einer Kombination jeder Bestehens/Fehler-Feststellung für jeden virtuellen Kontrollabschnitt eine Gesamt-Bestehens/Fehler-Angabe zu präsentieren.

7. Verfahren nach Anspruch 1, wobei eine Toleranz zu jedem Kontrollabschnitt längs der geometrischen Einheit variiert.

## Revendications

1. Procédé pour déterminer si une pièce est fabriquée dans les limites de tolérances prédéfinies, le procédé comprenant les étapes :
(a) de prévision d'une caméra pour capturer une image bidimensionnelle unique ou un flot d'images bidimensionnelles d'une pièce ;
(b) de réception, par un module informatique, de l'image ou du flot d'images ;
(c) d'obtention, de mise à l'échelle, de positionnement et d'affichage d'un dessin de CAO de ladite pièce sur une unité d'affichage ;
(d) de superposition du dessin de CAO sur l'image ou le flot d'images sur un afficheur de sorte que le dessin de CAO et l'image de la pièce soient alignés ;
(e) de définition d'au moins une entité géométrique dans le dessin de CAO, ladite entité géométrique étant une partie de ladite pièce, et pour chaque entité de définition d'un coefficient de densité qui est supérieur ou égal à 1;
(f) de définition d'une pluralité de sections de contrôle virtuelles dans chacune desdites entités géométriques, ladite pluralité de sections de contrôle virtuelles étant créées avec une densité qui correspond au coefficient de densité multiplié par l'espace de CAO équivalent à la distance de pixel à pixel;
(g) pour chaque section de contrôle virtuelle, de détermination de l'orientation de celle-ci;
(h) d'exécution d'une transformation d'espace de CAO à espace d'image de chaque section de contrôle virtuelle;
(i) de calcul d'un écart entre le dessin de CAO et la pièce au niveau de chaque section de contrôle virtuelle sur la base de la transformation effectuée à l'étape (h);
(j) de fourniture, à l'utilisateur, soit d'une indication de l'écart entre le dessin de CAO et la pièce au niveau de chaque section de contrôle virtuelle, soit d'une indication des écarts minimum et maximum entre le dessin de CAO et la pièce sur l'entité géométrique et de l'emplacement sur l'entité géométrique de ces écarts minimum et maximum;
(k) de comparaison de l'écart à une tolérance prédéterminée afin de déterminer si la pièce au niveau de chaque section de contrôle virtuelle est dans les limites de la tolérance prédéterminée, une tolérance au niveau d'une section de contrôle virtuelle étant égale ou différente d'une tolérance au niveau d'une autre section de contrôle virtuelle; et
(l) de fourniture, à un utilisateur, d'une indication de la détermination que chaque section de contrôle virtuelle est dans les limites de la tolérance prédéterminée.

2. Procédé selon la revendication 1, dans lequel ladite étape (j) comprend l'étape d'affichage visuellement de l'indication sur ladite unité d'affichage.

3. Procédé selon la revendication 1, dans lequel ladite étape (1) comprend l'étape d'affichage visuellement de l'indication sur ladite unité d'affichage.

4. Procédé selon la revendication 1, comprenant en outre la présentation à l'utilisateur d'une indication globale de réussite/échec, basée sur une combinaison de chaque détermination de réussite/échec pour chaque section de contrôle virtuelle.

5. Système pour comparer visuellement une pièce à un dessin de CAO de ladite pièce dans une mémoire d'ordinateur ou sur un écran, le système étant conçu pour effectuer toutes les étapes du procédé de la revendication 1.

6. Système selon la revendication 5, dans lequel ledit système est conçu pour présenter à l'utilisateur une indication globale de réussite/échec, basée sur une combinaison de chaque détermination de réussite/échec pour chaque section de contrôle virtuelle.

7. Procédé selon la revendication 1, dans lequel une tolérance à chaque section de contrôle varie le long de ladite entité géométrique.
